(19) Europäisches Patentamt
European Patent Office
Office européen des brevets

(11) **EP 3 836 383 A1**

(12) **EUROPÄISCHE PATENTANMELDUNG**

(43) Veröffentlichungstag:
**16.06.2021 Patentblatt 2021/24**

(51) Int Cl.:
*H02M 7/5387* (2007.01)    *G01R 27/26* (2006.01)
*H02M 1/00* (2006.01)

(21) Anmeldenummer: **19214654.6**

(22) Anmeldetag: **10.12.2019**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
**KH MA MD TN**

(71) Anmelder: **FRONIUS INTERNATIONAL GmbH**
**4643 Pettenbach (AT)**

(72) Erfinder: **Die Erfindernennung liegt noch nicht vor**

(74) Vertreter: **Patentanwälte Pinter & Weiss OG**
**Prinz-Eugen-Straße 70**
**1040 Wien (AT)**

(54) **VERFAHREN ZUR IDENTIFIKATION EINER FILTERINDUKTIVITÄT EINES NETZWECHELRICHTERS**

(57)    Verfahren zum Betreiben eines Wechselrichters (1), wobei das Verfahren die folgenden Schritte aufweist:
- mittels einer Schaltungseinheit (4) des Wechselrichters (1) Anlegen einer Wechselspannung an eine Phasenleitung (3), in der eine Filterinduktivität (2) angeordnet ist,
- Ermitteln eines Spulenstroms ($i_L$) der Filterinduktivität (2) und Ermitteln einer Spulenspannung ($u_L$) der Filterinduktivität (2),
- Ermitteln eines ersten Werts ($L(I_x)$) der Filterinduktivität (2) für einen ersten Wert des Spulenstroms ($I_x$),
- Gegebenenfalls ermitteln zumindest eines weiteren Wertes der Filterinduktivität (2) für zumindest einen weiteren Wert des Spulenstroms,
- Ermitteln eines auf den Spulenstrom bezogenen Induktivitätsprofils (6) der Filterinduktivität (2) unter Verwendung des ermittelten ersten Wertes der Filterinduktivität und gegebenenfalls unter Verwendung des zumindest einen ermittelten weiteren Wertes der Filterinduktivität,
- Regeln der Schaltungseinheit (4) des Wechselrichters (1) mittels einer Regeleinheit (5) zur Erzeugung eines Wechselstroms in der Phasenleitung (3), wobei zumindest ein Parameter der Regelung gemäß dem ermittelten stromabhängigen Induktivitätsprofil (6) laufend an den aktuellen Spulenstrom angepasst wird.

Fig. 1

EP 3 836 383 A1

**Beschreibung**

Die gegenständliche Offenbarung betrifft ein Verfahren zum Betreiben eines Wechselrichters und einen Wechselrichter.

Zur Filterung des von der Schaltungseinheit eines Wechselrichters erzeugten Wechselstroms werden in den einzelnen Phasenleitern der Wechselstromseite Filterspulen verbaut. Für ein gutes Regelverhalten ist es vorteilhaft, wenn die Filterspulen ein ausreichend lineares Verhalten aufweisen, was relativ teure Filterspulen ausreichender Größe voraussetzt. Filterspulen werden zunehmend im Bereich nicht-linearer Induktivität betrieben um eine kleinere Bauform zu ermöglichen, oder weil die Kernmaterialien eine nicht-lineare Charakteristik der Induktivität bewirken. Nicht-Linearitäten werden auch gezielt eingesetzt, um unterschiedliche Anforderungen durch verschiedene Betriebsbereiche besser zu erfüllen. Weicht die angenommene Charakteristik bzw. das Induktivitätsprofil der Spule von der tatsächlichen Charakteristik ab, kann sich das problematisch auf die Sinuswellenform des Stromes auswirken.

Aus US 2015/0016162 A1 ist es bekannt, bei der Regelung einer Pulsweitenmodulation für einen Photovoltaik-Wechselrichter, in Abhängigkeit einer aktuellen Stromstärke einen einer Filterinduktivität zugeordneten Wert zu ermitteln und in der Regelung zu berücksichtigen. Der zugeordnete Wert der Filterinduktivität wird dabei aus einer Zuordnungstabelle oder einer Näherungsformel ermittelt. In beiden Fällen wird das Induktivitätsprofil als bekannt vorausgesetzt.

Unter Laborbedingungen kann ein Induktivitätsprofil einer Filterspule oder einer Induktivität mit heutigem Stand der Technik relativ einfach ermittelt werden und für eine Steuerung oder Regelung hinterlegt werden. Die Laborbedingungen unterscheiden sich jedoch in der Regel von den Einbau- und Betriebsbedingungen einer Induktivität. Meistens bezieht sich das hinterlegte Induktivitätsprofil auf den Durchschnitt einer Stichprobe von mehreren Induktivitäten und nicht auf die tatsächlich verbaute Induktivität. Sobald eine Induktivität in einem Gerät verbaut ist, wird es sehr schwierig, ein brauchbares Induktivitätsprofil zu ermitteln, besonders dann, wenn sich das Gerät in Betrieb befindet. Erschwerend kann ein Strom, der durch die Induktivität im Gerät fließt, Verzerrungen hoher Frequenz beinhalten.

In der Praxis besteht daher oft das Problem, dass das hinterlegte Induktivitätsprofil für eine Induktivität bzw. Filterspule vom tatsächlichen Induktivitätsprofil (d.h. dem tatsächlichen Verlauf des Induktivitätswerts der Induktivität in Bezug auf die Stromstärke) aus den eben genannten Gründen erheblich abweicht. Davon abgesehen sind Induktivitätsprofile von Induktivitäten durch Alterung, veränderliche Umgebungsbedingungen und Fertigungstoleranzen nicht einheitlich oder über die Zeit konstant. Besonders wenn Induktivitäten im nicht-linearen Bereich betrieben werden, können Abweichungen vom hinterlegten Induktivitätsprofil ein problematisches Ausmaß erreichen. Schlussendlich kann auch die zuvor stattgefundene Abfolge von Änderungen des Stroms durch die Induktivität einen Einfluss auf den tatsächlich gerade vorliegenden Wert der Induktivität bei einem bestimmten Strom haben. Das heißt, dass es bei einem Stromwert nicht nur einen, sondern mehrere mögliche Werte für die Induktivität geben kann. Die Ursache dafür liegt im Vorliegen einer Hysterese bei der Magnetisierung von Kernmaterialien von Induktivitäten bzw. Filterinduktivitäten.

Die gegenständliche Offenbarung betrifft Verfahren und Vorrichtungen, mit denen diese und weitere Probleme des Standes der Technik behoben werden können.

In einem ersten Aspekt betrifft die gegenständliche Offenbarung ein Verfahren zum Betreiben eines Wechselrichters, welches die folgenden Schritte aufweist:

- mittels einer Schaltungseinheit des Wechselrichters Anlegen einer Wechselspannung an eine Phasenleitung, in der eine Filterinduktivität angeordnet ist,

- Ermitteln von für einen Spulenstrom und eine Spulenspannung der Filterinduktivität charakteristischen Werten im Bereich einer Mehrzahl von Messpunkten, wobei zumindest jeweils zwei Messpunkte an zumindest einer Flanke eines Stromrippels liegen,

- Ermitteln, aus den charakteristischen Werten, eines ersten Werts der Induktivität der Filterinduktivität für einen ersten Wert des Spulenstroms,

- Gegebenenfalls ermitteln zumindest eines weiteren Wertes der Induktivität der Filterinduktivität für zumindest einen weiteren Wert des Spulenstroms,

- Ermitteln zumindest eines auf den Spulenstrom bezogenen Induktivitätsprofils der Filterinduktivität unter Verwendung des ermittelten ersten Wertes der der Induktivität der Filterinduktivität und gegebenenfalls unter Verwendung des zumindest einen ermittelten weiteren Wertes der Filterinduktivität,

- Regeln der Schaltungseinheit des Wechselrichters mittels einer Regeleinheit zur Erzeugung eines Wechselstroms in der Phasenleitung, wobei zumindest ein Parameter der Regelung gemäß einem ermittelten stromabhängigen Induktivitätsprofil laufend an den aktuellen Wert der Induktivität angepasst wird.

Die Regelung des Wechselrichters verfügt somit immer über ein aktuelles Induktivitätsprofil, dass dem tatsächlichen Induktivitätsprofil der Filterinduktivität sehr genau entspricht, wodurch die Regelqualität verbessert wird.

In einer vorteilhaften Ausführungsform des Verfahrens kann das Ermitteln des ersten Werts der Filterinduktivität die folgenden Schritte umfassen:

- Ermitteln einer ersten Flankensteigung $m_x$ eines Stromrippels für den ersten Wert des Spulenstroms,
- Ermitteln eines ersten Werts $U_x$ der Spulenspannung der ersten Flankensteigung,
- Ermitteln des ersten Werts $L(I_{L_y})$ der Filterinduktivität aus der ersten Flankensteigung und dem ersten Wert der Spulenspannung gemäß der Formel

$$L(I_{L_y}) = \frac{U_x}{m_x} \ .$$

Die Auswertung der Flankensteigung von Stromrippeln erlaubt eine sehr genaue Ermittlung eines Wertes der Filterinduktivität bei einer bestimmten Stromstärke. Die Flankensteigung des Stromrippels entspricht dabei der Ableitung des Stroms nach der Zeit di/dt, sodass sich der Wert der Filterinduktivität unmittelbar durch Verwendung der Formel für die Induktivität

$$u_L = L \cdot \frac{di}{dt}$$

beziehungsweise

$$L = u_L \cdot \frac{dt}{di}$$

ermitteln lässt.

Das Ermitteln einer Flankensteigung erfordert üblicherweise die Auswertung von zumindest zwei Messpunkten, die an derselben Flanke eines Stromrippels liegen. Jede Flanke eines Stromrippels liegt zwischen zwei Schaltpunkten der Schaltungseinheit, sodass die Zeitdauern der Flanken in der Regelung bekannt sind. Diese Kenntnis kann dazu genutzt werden sicherzustellen, dass für die Ermittlung der Flankensteigung nur Messwerte verwendet werden, die auf einer einzigen Flanke desselben Stromrippels liegen. Genauso ist bekannt, ob gerade eine steigende oder eine fallende Flanke eines Stromrippels vorliegt. Wenn die Ermittlung der Induktivität mit nur zwei Messpunkten auf einer Flanke durchgeführt werden soll, wird ein Messpunkt nach einem ersten Schaltpunkt und ein weiterer Messpunkt vor einem folgenden Schaltpunkt vorgesehen. Die zwei Messpunkte liegen dabei möglichst weit auseinander.

Zur Erhöhung der Genauigkeit bzw. zur Berücksichtigung einer Krümmung einer Flanke werden mehr als zwei Messpunkte auf einer Flanke vorgesehen. Gegebenenfalls können auch mehr als zwei Messpunkte zur Ermittlung der Flankensteigung herangezogen und ein Mittelwert für die Berechnung der Filterinduktivität herangezogen werden. Dabei werden Mittelwerte für den Spulenstrom und die Spulenspannung über eine Flanke eines Stromrippels gebildet, woraus der entsprechende Induktivitätswert für einen mittleren Spulenstrom $I_{L_y}$ ermittelt wird. Dadurch kann beispielsweise in erster Näherung der Einfluss der Krümmung der Flanken des Rippelstroms berücksichtigt werden. Bei stark nichtlinearen Induktivitäten oder entsprechend ausgedehnten Rippelflanken, wie sie z.B. beim Einsatz H-Brücken auftreten können, unterscheidet sich nämlich die Flankensteigung am Anfang der Flanke von der Flankensteigung am Ende der Flanke. Durch die Verwendung eines Mittelwertes kann eine verbesserte Regelqualität erzielt werden. Falls im Zuge der Regelung Flanken von Stromrippeln entstehen, die für eine Messung der Flankensteigung zu kurz sind (d.h. in denen insbesondere nur ein einziger Messpunkt liegt), werden diese Flanken bei der Auswertung nicht berücksichtigt.

Eine Charakteristik bzw. ein Induktivitätsprofil einer Filterspule lässt sich mit charakteristischen Werten erfassen. Charakteristische Werte ergeben sich grundsätzlich aus der Abhängigkeit von Spulenstrom und Spulenspannung und deren Änderungsraten. Als Beispiel in diesem Zusammenhang sei als charakteristischer Wert die Steigung einer Flanke eines Stromrippels genannt. Anstelle des Stromes kann auch der magnetische Fluss für die Formulierung von charakteristischen Werten herangezogen werden. Änderungen der Charakteristik bzw. des Induktivitätsprofils einer Filterspule, die z.B. in Abhängigkeit von ihrer Temperatur, der Amplitude des Wechselstroms, der Schaltfrequenz bzw. der verwendeten Schaltungseinheit/Topologie in Erscheinung treten, können ebenfalls mit geeigneter Erfassung dieser Abhängigkeiten und deren zeitlichen Zusammenhang als charakteristische Werte ermittelt bzw. abgebildet werden.

Die charakteristischen Werte umfassen in jedem Fall solche, aus denen sich zumindest ein Wert der Induktivität einer Spule ermitteln lässt. Mehrere von einem Spulenstrom und Spulenspannung abhängige Werte der Induktivität werden zur Ermittlung zumindest eines Induktivitätsprofiles herangezogen.

In vorteilhafter Weise kann die Ermittlung des Spulenstroms durch eine Messung mit einer Abtastfrequenz erfolgen, die zumindest dem zweifachen und vorzugsweise einem Vielfachen einer Taktfrequenz einer über die Schaltungseinheit umgesetzten Pulsweitenmodulation entspricht. Diese "Überabtastung" (bzw. "Oversampling") erlaubt eine sehr genaue Auswertung des Verlaufs der Stromrippel. Die Stromrippel entstehen z.B. durch Schaltvorgänge zur Pulsweitenmodulation. Das Verfahren kann mit unterschiedlichen Arten von Pulsweitenmodulationen ausgeführt werden, beispielsweise auf Basis einer fixen Frequenz oder einer variablen Frequenz.

In vorteilhafter Weise kann die Flankensteigung durch Bilden der Stromdifferenz zwischen zumindest zwei Abtastschritten und unter Berücksichtigung der Abtastfrequenz ermittelt werden. Der Wert für die Flankensteigung kann somit als Differenz des Messwerts von aufeinanderfolgenden zwei Strommessungen dividiert durch die Länge des Messintervalls auf einfache Weise in guter Näherung ermittelt werden.

In vorteilhafter Weise können nach der Ermittlung des Induktivitätsprofils dessen Steigung und/oder Krümmung ermittelt werden.

In vorteilhafter Weise kann bei der Regelung der Schaltungseinheit des Wechselrichters mittels einer Regeleinheit zur Erzeugung eines Wechselstroms in einer Phasenleitung zumindest ein Parameter der Regelung laufend an den aktuellen Wert der Steigung und/oder Krümmung des Induktivitätsprofils angepasst werden.

Wenn der Wechselrichter mehrere Phasenleitungen mit jeweils einer Filterinduktivität aufweist, kann in einer weiteren vorteilhaften Ausführungsform zumindest ein weiteres Induktivitätsprofil einer weiteren Filterinduktivität in einer weiteren Phasenleitung ermittelt und bei der Regelung berücksichtigt werden. Das hierin offenbarte Verfahren lässt sich somit sowohl auf einphasige, als auch auf mehrphasige Wechselrichter vorteilhaft anwenden. Der Begriff "eine Filterinduktivität" ist dabei auch so zu verstehen, dass "eine Filterinduktivität" aus mehreren miteinander verschalteten Filterinduktivitäten gebildet sein kann. Der Einfachheit halber werden die in Summe für die Regelung wirksamen Filterinduktivitäten einer Phase als "eine Filterinduktivität" betrachtet.

In vorteilhafter Weise kann ein hierin offenbartes Verfahren vor der ersten Inbetriebnahme des Wechselrichters und/oder in planmäßigen Intervallen vor einer oder vor jeder Inbetriebnahme des Wechselrichters und/oder regelmäßig oder ständig während des Betriebs des Wechselrichters durchgeführt werden. Die gewählte Strategie hängt auch von den vorhandenen Ressourcen ab. Beispielsweise bindet die Ermittlung von Spulenstrom und Spulenspannung mit einer ausreichend hohen Abtastfrequenz ("Oversampling") sowie die Ermittlung der Werte der Filterinduktivität und gegebenenfalls die Anpassung des Induktivitätsprofils Rechenkapazität in der Regeleinheit. Um diese freizugeben kann die Ermittlung daher beispielsweise über eine (oder mehrere) Periode(n) erfolgen, wobei das ermittelte Induktivitätsprofil gegebenenfalls schrittweise in einem Speicher abgelegt wird. Die Regelung kann dann in weiterer Folge auf die abgespeicherten Werte zugreifen, ohne zusätzliche Rechenkapazität zu benutzen. Die nächste Ermittlungsperiode kann dann entweder durch ein bestimmtes Ereignis ausgelöst werden (z.B. wenn die Regeleinheit eine verringerte Regelqualität feststellt), oder die Ermittlung kann in regelmäßigen Intervallen während des Betriebs erfolgen.

In einem weiteren Aspekt betrifft die gegenständliche Offenbarung einen Wechselrichter mit einer Schaltungseinheit, mit der eine Wechselspannung an zumindest eine Phasenleitung anlegbar ist, wobei in der Phasenleitung eine Filterinduktivität angeordnet ist und wobei die Schaltungseinheit mittels einer Regeleinheit geregelt wird, wobei ein Spulenstrom der Filterinduktivität und eine Spulenspannung der Filterinduktivität von der Regeleinheit ermittelbar ist, und wobei die Regeleinheit ausgebildet ist, die folgenden Schritte auszuführen:

- Ansteuern der Schaltungseinheit zum Anlegen einer Wechselspannung an eine Phasenleitung des Wechselrichters,

- Ermitteln eines ersten Werts der Filterinduktivität für einen ersten Wert des Spulenstroms,

- Gegebenenfalls ermitteln zumindest eines weiteren Wertes der Filterinduktivität für einen weiteren Wert des Spulenstroms,

- Ermitteln eines auf den Spulenstrom bezogenen Induktivitätsprofils der Filterinduktivität unter Verwendung des ermittelten ersten Wertes der Filterinduktivität und gegebenenfalls unter Verwendung des zumindest einen ermittelten weiteren Wertes der Filterinduktivität,

- Regeln der Schaltungseinheit des Wechselrichters zur Erzeugung eines Wechselstroms in der Phasenleitung, wobei zumindest ein Parameter der Regelung gemäß dem ermittelten stromabhängigen Induktivitätsprofil laufend an den aktuellen Spulenstrom angepasst wird.

Ein solcher Wechselrichter ermöglicht einerseits eine verbesserte Regelleistung und damit einhergehend eine idealere Sinusform der Wechselgrößen am Wechselrichterausgang. Andererseits können günstigere Bauteile verwendet werden, die oftmals eine nicht bewältigbare Herausforderung für übliche Regelungen darstellen. Insbesondere kleinere und leichtere Induktivitäten ermöglichen das Vorantreiben der Miniaturisierung und Kostenoptimierung. Die kleineren und leichteren Induktivitäten weisen aber durch die früher eintretende magnetische Sättigung eine nichtlineare Abhängigkeit der Induktivität vom Strom auf, welche durch die erfindungsgemäßen Lösungen berücksichtigt wird.

In vorteilhafter Weise kann die Regeleinheit ausgebildet sein, das Induktivitätsprofil der Filterinduktivität vor der ersten Inbetriebnahme des Wechselrichters und/oder in planmäßigen Intervallen vor einer oder vor jeder Inbetriebnahme des Wechselrichters und/oder regelmäßig oder ständig während des Betriebs des Wechselrichters durchzuführen. Dadurch lässt sich stets eine optimale Regelleistung gewährleisten.

In einer vorteilhaften Ausgestaltung kann der Wechselrichter mehrere Phasen mit jeweils einer Filterinduktivität aufweisen, wobei für jede Filterinduktivität ein Induktivitätsprofil ermittelbar ist. Dies erlaubt es, die gegenständlichen Lehren auch auf mehrphasige Wechselrichter vorteilhaft anzuwenden.

Die gegenständliche Erfindung wird nachfolgend unter Bezugnahme auf die Figuren 1 bis 3 näher erläutert, die beispielhaft, schematisch und nicht einschränkend vorteilhafte Ausgestaltungen der Erfindung zeigen. Dabei zeigt

Fig.1        eine beispielhafte schematisierte Schaltungsanordnung eines Wechselrichters,

Fig. 2       eine diagrammhafte Darstellung von qualitativen Induktivitätsprofilen

Fig. 3a      eine diagrammhafte Darstellung eines Stromverlaufs

Fig. 3b      eine diagrammhafte Darstellung eines Stromverlaufs mit Spulenspannung

Fig. 3c      eine diagrammhafte Darstellung eines Stromverlaufs mit zwei Messpunkten und

Fig. 4       eine diagrammhafte Darstellung der Anpassung eines Induktivitätsprofils

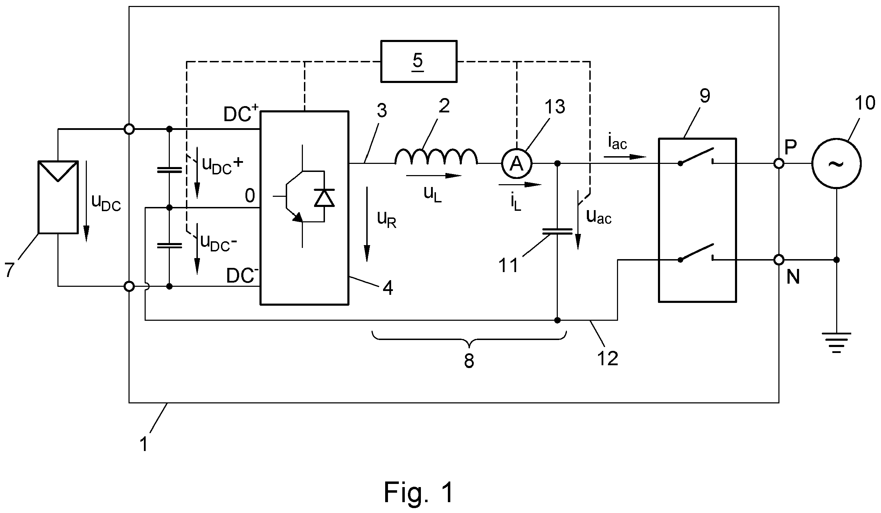

Die in Fig. 1 dargestellte Schaltanordnung eines Wechselrichters 1 wandelt ein Gleichstrompotential $U_{DC}$ von einer Gleichstromquelle 7 mithilfe einer an sich bekannten Schaltungseinheit 4 in eine getaktet geschaltete, rechteckig verlaufende Rechteck-Wechselspannung $u_R$ um, die an eine Phasenleitung 3 angelegt wird. Die rechteckig verlaufende Rechteck-Wechselspannung $u_R$ wird dann von einer Filtereinheit 8 in eine annähernd sinusförmig verlaufende Wechselspannung (Filterkondensatorspannung $u_{ac}$) beziehungsweise einen dementsprechend annähernd sinusförmig verlaufenden Wechselstrom $i_{ac}$ umgewandelt.

Der Wechselrichter 1 kann über ein Netzrelais 9 mit den Leitungen eines Stromnetzes 10 verbunden werden, wobei im dargestellten einfachen Fall der Wechselrichter an eine Phase P und einen Neutralleiter N des Stromnetzes 10 angeschlossen ist. Die Wechselspannung $u_{ac}$ speist bei geschlossenem Netzrelais 9 einen Phasenstrom $i_{ac}$ in das Stromnetz 10 ein.

Für die Ermittlung eines Induktivitätsprofils ist der Wechselrichter üblicherweise mit den Phasen eines Versorgungsnetzes verbunden. Das Induktivitätsprofil kann aber auch mit einem Wechselrichter ohne Verbindung zu Phasen eines Versorgungsnetzes durch geeignete Schaltvorgänge und einer Verbindung zum Neutralleiter des Versorgungsnetzes vor einem Einspeisebetrieb ermittelt werden. Im Rahmen der Herstellung eines Wechselrichters werden an diesem in der Regel Tests durchgeführt, im Rahmen welcher Ströme fließen, die mit den gewöhnlich im Betrieb auftretenden Strömen vergleichbar sind. So können ohne zusätzlichen Zeit- und Mittelaufwand bereits bei der Herstellung genaue Induktionsprofile vom Wechselrichter selbst ermittelt werden. Dadurch kann sichergestellt werden, dass schon bei der ersten Inbetriebnahme bzw. dem ersten Einspeisebetrieb ein einwandfreier Strom erzielt wird.

Die Filtereinheit 8 umfasst eine in der Phasenleitung 3 angeordnete Filterspule 2 und einen Filterkondensator 11. Die Filterspule 2 ist mit ihrem ersten Ende direkt mit der Schaltungseinheit 4 verbunden, vom zweiten Ende der Filterspule 2 führt die Phasenleitung 3 weiter zum Netzrelais 9. Der Filterkondensator 11 ist im Bereich zwischen dem zweiten Ende der Filterspule 2 und dem Netzrelais 9 zwischen der Phasenleitung 3 und dem Neutralleiter 12 angeordnet.

Die Schaltungseinheit 4 ist in Fig. 1 nur schematisch dargestellt, wobei zahlreiche Topologien von Schaltungseinheiten 4 bekannt sind, die für die Erzeugung der Wechselspannung verwendet werden können. Die in Fig. 1 dargestellte Schaltungseinheit 4 entspricht einer Dreipunkt-Schaltung, wobei die Phasenleitung 3 mit drei Gleichstrompotentialen beaufschlagt werden kann, einem positiven Gleichstrompotential DC+, einem negativen Gleichstrompotential DC- und einem neutralen Gleichstrompotential 0 von einem Zwischenkreismittelpunkt, der mit dem Neutralleiter 12 verbunden ist. Die Lehren der gegenständlichen Offenbarung können jedoch auch auf Topologien angewendet werden, die lediglich zwei Gleichstromeingänge (z.B. DC+ und DC-) oder auch nur einen Gleichstromeingang, dessen Potential vom Neutralleiter unterscheidet, aufweisen. Eine Topologie der Schaltungseinheit 4, die für den in Fig. 1 dargestellten Fall verwendet werden kann, ist beispielsweise die sogenannte NPC-Topologie, es können jedoch auch beliebige andere Topologien verwendet werden, wobei die Anpassung der Schaltung an eine andere Topologie zu den Fähigkeiten des Durchschnittsfachmanns zählt. Die Schaltung kann beispielsweise auch zwei oder drei Phasenausgänge mit jeweils einer Filterspule aufweisen, wie dies im Fachbereich bekannt ist. Die Topologie der Schaltanordnung 4 des Wechselrichters kann beispielsweise ausgewählt sein aus H-Brücke, H5, HERIC, REFU, FB-DCBP, FB-ZVR, NPC, Conergy-NPC und mit diesen verwandten Topologien. Die derart bezeichneten Topologien sind im Fachbereich bekannt und müssen daher hierin nicht näher erläutert werden.

Die Schalteinheit 4 ist mit einer Regeleinheit 5 verbunden, welche das Öffnen und Schließen der in der Schalteinheit 4 vorgesehenen Halbleiterschalter regelt. Üblicherweise wird dabei ein Pulsweitenmodulationsschema angewendet. Je nach Regelschema verfügt die Regeleinheit 5 über mehrere Messwerte, die als Eingangsgrößen der Regelung verwendet werden. In Fig. 1 sind als Eingangsgrößen der Regelung die Zwischenkreisspannungen $u_{dc}^+$ und $u_{dc}^-$ des positiven und des negativen Gleichstrompotentials gegenüber dem Zwischenkreismittelpunkt (d.h. die Spannungen über die Zwischenkreiskondensatoren), die Wechselspannung $u_{ac}$ über den Filterkondensator 11 und der Spulenstrom $iL$ durch die Filterspule 2 durch Strichlinien beispielhaft und schematisch dargestellt. Die zur Ermittlung dieser Eingangsgrößen erforderlichen Messeinrichtungen und Schaltungen sind dem Fachmann bekannt und müssen hierin nicht detailliert beschrieben werden. Je nach Topologie können auch weitere oder andere Messwerte als Eingangsgrößen der Regelung vorgesehen sein. Gegebenenfalls können auch andere Größen gemessen werden, wenn sich aus diesen die für die Regelung erforderlichen Eingangsgrößen direkt oder indirekt ermitteln lassen.

So lassen sich in dem in Fig. 1 dargestellten Beispiel etwa die Spulenspannung $u_L$ als Subtraktion der von der Schaltungseinheit 4 erzeugten Rechteck-Wechselspannung $u_R$ und der Filterkondensatorspannung $u_{ac}$ ermitteln. Die Rechteck-Wechselspannung $u_R$ ist wiederum anhand der jeweiligen Schalterstellung der Schaltungseinheit 4 und der Werte der Zwischenkreisspannungen ermittelbar. Der Spulenstrom iL kann beispielsweise durch einen vor oder nach der Filterspule 2 in der Phasenleitung 3 angeordneten Strommesser 13 direkt ermittelt werden. Gegebenenfalls kann eine Strommessung auch an einer anderen Stelle erfolgen, beispielsweise kann der Phasenstrom $i_{ac}$ und der Strom über den Filterkondensator 11 gemessen werden, wobei sich der Spulenstrom $i_L$ aus diesen Werten ergibt. Der Spulenstrom kann jedoch auch indirekt ermittelt werden, beispielsweise durch Messen des magnetischen Flusses der Filterspule. Für die hierin offenbarten Verfahren ist es wesentlich, dass eine Möglichkeit besteht, auf eine beliebige Weise den Spulenstrom $i_L$ und die Spulenspannung $u_L$ zu ermitteln.

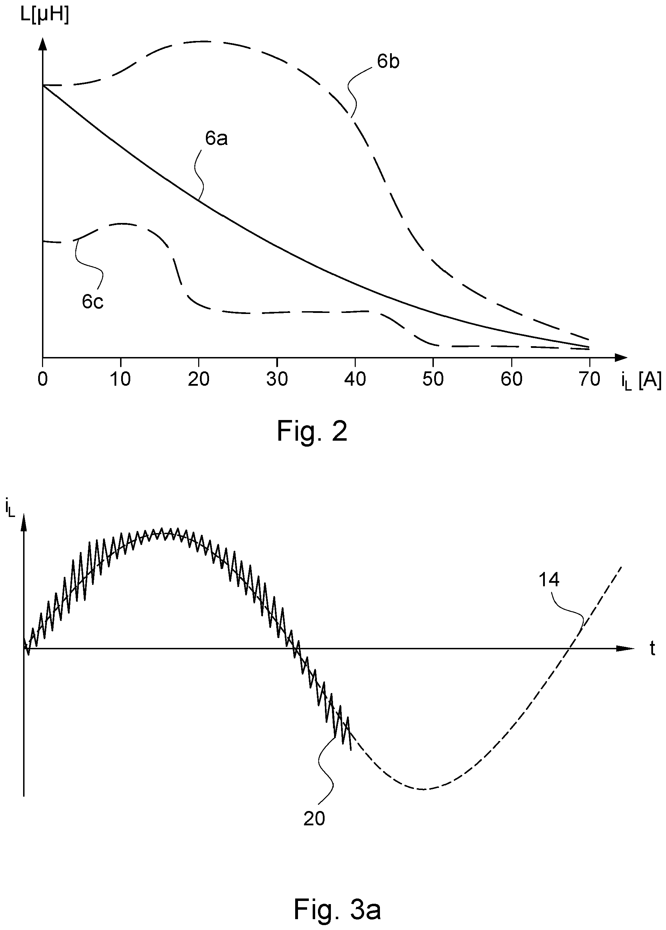

Die Filterspule 2 kann in Strombereichen betrieben werden, in dem ein nichtlineares Induktivitätsprofil vorliegt, wie es anhand der unterschiedlichen Verläufe des Induktivitätsprofils 6a, 6b und 6c in Fig. 2 beispielhaft und qualitativ dargestellt ist. Die Induktivität L der Filterspule 2 ist durch ein Induktivitätsprofil (6a, 6b, 6c) als ein vom Spulenstrom abhängiger Wert definiert.

Die Regeleinheit 5 des Wechselrichters verwendet als Parameter auch den Wert der Induktivität der Filterspule 2. Wenn jedoch ein falscher Wert verwendet wird, führt dies zu einer schlechten Regelqualität, was zu unerwünschten Spannungs- bzw. Stromschwankungen führen kann. Dies kann einerseits eine Blindleistung unerwünscht verändern oder die Sinusform des Stromes $i_{ac}$ verzerren, andererseits können Bauteile übermäßig beansprucht werden oder es kann sogar zu Fehlabschaltungen des Wechselrichters kommen.

Um (günstige und kleine) Filterspulen 2 mit einem stark ausgeprägtem nichtlinearem Induktivitätsprofil 6 verwenden zu können, können die von der Induktivität abhängigen Parameter der Regelung in Abhängigkeit vom aktuellen Wert des Spulenstroms iL ständig angepasst werden. Die Messung bzw. Ermittlung des Spulenstroms erfolgt bei einem erfindungsgemäßen Wechselrichter sehr genau und mit einer hohen Abtastungsrate, sodass die Regelung über den gesamten Phasenverlauf sehr genau an den aktuellen Wert des Spulenstroms angepasst werden kann. Somit kann eine hohe Regelgüte erzielt werden, allerdings nur insofern das Induktivitätsprofil 6 korrekt ist.

Das Induktivitätsprofil 6 einer Filterspule 2 kann sich jedoch durch Umgebungseinflüsse (z.B: Temperatur, Magnetfelder benachbarter Drosseln oder dergleichen) und/oder Alterung erheblich verändern. Dazu kommen noch die herstellungsbedingten Toleranzen und Abweichungen der Induktivitäten von Filterspulen. Trotz der (vermeintlich) optimalen Anpassung der Reglung an ein nur vermeintlich richtiges Induktivitätsprofil 6 können daher in der Praxis Regelfehler auftreten.

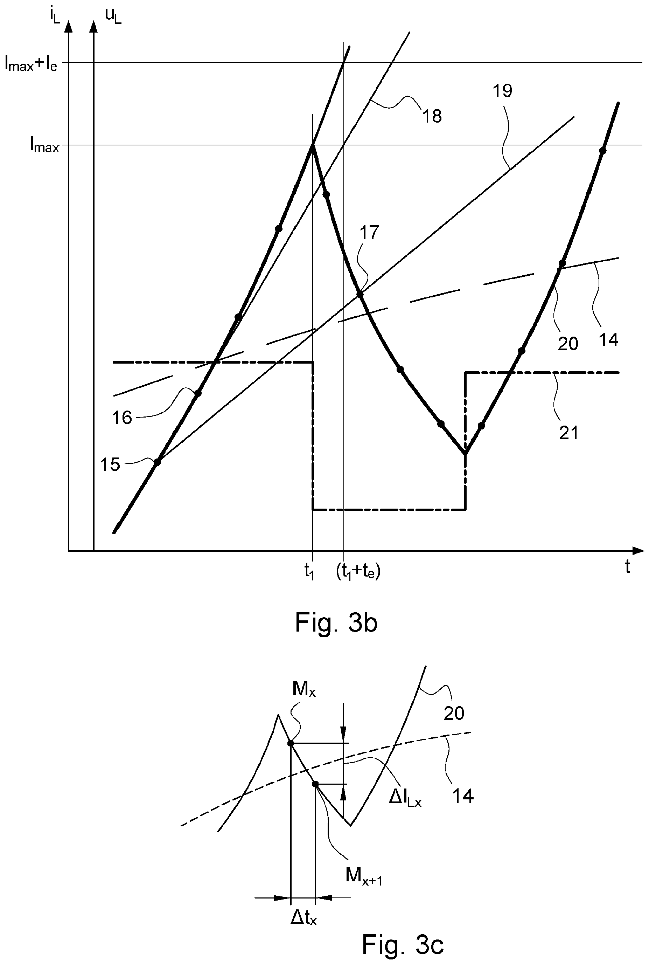

In Fig. 3a ist ein Verlauf eines Spulenstroms iL über die Zeit t in einem Diagramm dargestellt. Abgesehen von den dargestellten Stromrippeln in Fig. 3a gibt es Verfahren zur Erzeugung eines Wechselstroms, bei denen die Stromrippel um ein Vielfaches größer sein können. Beispielsweise ist aus dem Stand der Technik ein Verfahren bekannt, bei dem jeder Stromrippel einen Nulldurchgang aufweist und dadurch speziell im Bereich der Stromamplitude der Grundwelle ein Induktivitätsprofil einer Filterinduktivität mit einem oder wenigen dieser großen Rippel ermittelt werden kann. Der Strom in Fig. 3a folgt im Wesentlichen einem sinusförmigen Verlauf (der sogenannten Grundwelle 14 des Stroms), weist jedoch deutlich erkennbare Stromrippel auf, die in den in Fig. 3b und 3c dargestellten Diagrammausschnitten vergrößert dargestellt sind. Die in den Diagrammausschnitten der Fig. 3b und 3c dargestellten Verläufe können sich dabei auf einem unterschiedlichen Bereich der Grundwelle 14 befinden, die Darstellung ist jedoch beliebig gewählt und ist nicht einschränkend auszulegen.

Das Auftreten solcher Stromrippel ist technisch bedingt und in einem gewissen Ausmaß nicht vermeidbar. Vor allem im Bereich der Stromamplituden können zu große Stromrippel jedoch Überströme bewirken, die zu einer Fehlabschaltung (oder gar zu einer Beschädigung von Bauteilen) führen können. Daher ist es ein weiteres Ziel der Erfindung, mit Hilfe eines genauen Induktivitätsprofils die Größe der Stromrippel vor deren Auftreten zu kennen und gegebenenfalls durch Anpassung des Modulationsverfahrens bzw. der Regelung der Schaltungseinheit in ihrer Größe zu begrenzen, um eine Fehlabschaltung zu vermeiden. Wesentlich für die Regelgüte ist dabei eine genaue Kenntnis der Parameter der Filterschaltung. Bei nicht-linearen Filterspulen 2 sind Insbesondere möglichst getreue Kenntnisse des Induktivitätsprofils 6 erforderlich.

Jeder Stromrippel weist eine ansteigende und eine abfallende Flanke auf, wobei die Flanken jeweils die Grundwelle 14 des Stroms kreuzen. Die Messabtastung des Spulenstroms iL erfolgt mit einer hohen Frequenz, sodass für jede Flanke eines Stromrippels eine Vielzahl an Messungen, beispielsweise zehn oder mehr Messungen, jedoch mindestens zwei, zur Verfügung stehen. Die Messabtastungen sind in Fig. 3b beispielhaft durch Messpunkte 15, 16, 17 dargestellt. In Fig. 3b ist zu erkennen, dass jede Flanke eine Krümmung aufweist. Die Krümmung der Flanke ist durch das nicht-lineare Verhalten der Filterspule 2 bedingt. Es ist auch möglich, die Krümmung einer Flanke mittels drei oder mehr Messpunkten auf einer Flanke besser zu berücksichtigen, indem zumindest zwei Werte der Induktivität an verschiedenen Stellen der gekrümmten Flanke ermittelt werden.

Zwischen zwei Messabtastungen auf einer Flanke eines Stromrippels kann eine Flankensteigung m des Stromrippels ermittelt werden. Eine zu niedrige Abtastrate bzw. ungeeignete Lage oder Auswahl der Messpunkte für die Ermittlung von Induktivitätswerten führt dabei zu unerwünschten Ergebnissen, wie dies anhand der Geraden 18 und 19 in Fig. 3b verdeutlicht wird. Die Gerade 18 wird durch die Messpunkte 15 und 16 gebildet und weist eine Steigung $m_x$ auf. Durch die Krümmung der Flanken des Spulenstroms bzw. Rippelstroms 20 weicht die Gerade 18 zunehmend von der Flanke mit den Messpunkten 15 und 16 ab. Eine Regelung, die beim Spulenstrom $I_{max}$ die fallende Flanke zum Zeitpunkt $t_1$ einleiten sollte, würde dies anhand eines einfachen Induktivitätsprofils vereinfacht skizziert gemäß der Steigung m der Gerade 18, erst zum Zeitpunkt $(t_1+t_e)$ einleiten. Zum Zeitpunkt $(t_1+t_e)$ würde der Spulenstrom bereits $I_{max}+I_e$ betragen, da sich der Spulenstrom durch die um $t_e$ verspätete Einleitung um $I_e$ weiter erhöht hätte. Noch größere Abweichungen würden sich ergeben, wenn bei der Ermittlung der Steigung m zwei Messpunkte herangezogen werden, die nicht auf einer Flanke liegen, beispielsweise die in Fig. 3b dargestellten Messpunkte 15 und 17. Die Gerade 19 durch die Messpunkte 15 und 17 veranschaulicht, dass das Erreichen von $I_{max}$ zu einem viel späteren Zeitpunkt von einer Regelung erwartet werden und dadurch noch deutlicher überschritten werden würde, als im Beispiel anhand Gerade 18. Die Regelung wäre in diesem Fall wahrscheinlich nicht mehr möglich. Um Fehlabschaltungen zu vermeiden und die Regelqualität zu verbessern, werden zur erfindungsgemäßen Ermittlung eines Induktivitätsprofils der Bezug der Messpunkte zur jeweiligen Flanke und insbesondere eine vorhandene Krümmung berücksichtigt.

In einem Diagrammausschnitt aus Fig. 3a sind in Fig. 3c beispielhaft zwei Messpunkte auf einer Flanke eines Stromrippels dargestellt. Dabei wird die Flankensteigung $m_x$ beispielsweise zwischen den beiden Messpunkten $M_x$ und $M_{x+1}$ ermittelt. Jeder Messpunkt $M_x$, umfasst einen Stromwert $I_{Lx}$ zum Zeitpunkt $t_x$ (x=1,2,..,n). Die Flankensteigung $m_x$ ergibt sich aus der Stromdifferenz $\Delta I_{Lx}$ dividiert durch die den Zeitraum zwischen den beiden Messabtastungen $\Delta t_x$ mit $\Delta I_{Lx}=(I_{L(x+1)}-I_{Lx})$ und $\Delta t_x=(t_{x+1}-t_x)$.

Weiters wird auch ein Wert $U_x$ der Spulenspannung $u_L$ für jeden oder mehrere Messpunkte ermittelt. Wie in Fig. 3b dargestellt ist, kann die als Strich-Punkt-Punkt-Linie 21 dargestellte Spulenspannung $u_L$ über die Dauer einer Flanke zur vereinfachten Darstellung als konstant angenommen werden.

Mit der Flankensteigung $m_x$ und der Spulenspannung $U_x$ kann ein von einem Spulenstrom $I_{Ly}$ abhängiger Wert der Induktivität $L(I_{Ly})$ gemäß der Formel

$$L(I_{L_y}) = \frac{U_x}{m_x}$$

ermittelt werden.

Der so ermittelte Wert der Induktivität bildet mit einem Spulenstrom $I_{Ly}$ ein Wertepaar für ein Induktivitätsprofil. Der Spulenstrom $I_{Ly}$ kann beispielsweise $I_{Ly} = I_{Lx}$ entsprechen, einem Mittelwert $I_{Ly} = (I_{L(x+1)}+I_{Lx})/2$, oder einem aus mehr als zwei Stromwerten $I_{Lx}$ ermittelten Wert. Letzteres macht besonders dann Sinn, wenn eine Steigung aus mehr als zwei Stromwerten ermittelt wird. Zusätzlich kann ein Wertepaar für ein Induktivitätsprofil mit weiteren charakteristischen Werten, wie z.B. einer Temperatur, einer Stromamplitude, dem Vorzeichen der Steigung $m_x$ ergänzt werden, auf Basis welcher eine Einteilung in verschiedene Induktivitätsprofile erfolgen kann. Diese weiteren charakteristischen Werte können sind entweder bereits von den Messpunkten umfasst, oder werden erst bezogen auf ein Wertepaar ermittelt.

Die Flankensteigung $m_x$ und die Spulenspannung $U_x$ kann mithilfe der oben beschriebenen Vorgehensweise für eine Vielzahl von unterschiedlichen Werten $I_{Lx}$ des Spulenstroms iL ermittelt werden, wobei die ermittelten Werte im Wesentlichen den gesamten Verlauf des Spulenstroms iL abdecken können, der die Grundwelle 14 des Stroms bildet. Damit lässt sich für ausreichend viele Werte des Spulenstroms iL jeweils ein Wert $L(I_{Ly})$ für die Induktivität der Filterspule 2 ermitteln, um den gesamten Verlauf des zumindest einen Induktivitätsprofils 6 über den relevanten Strombereich ausreichend genau ermitteln zu können. Dies kann beispielsweise durch ein passendes Regressionsverfahren, beispielsweise eine lineare Regression, erfolgen. In praktischen Versuchen hat sich eine Anpassung an eine Polynomfunktion 2ten Grades für manche Filterspulen 2 als ausreichend gute Näherung erwiesen, je nach Anwendung können jedoch auch Polynomfunktionen höherer Grade oder auch 1-sten Grades (d.h. Darstellung durch eine Gerade) verwendet werden, wenn dies vorteilhaft ist. Mit der Anpassung bzw. Regression kann das Induktivitätsprofil 6 als einfache Formel dargestellt werden, welche die Induktivität der Filterspule 2 in Abhängigkeit vom Spulenstrom darstellt.

Beispielsweise kann ein Induktivitätsprofil als Polynom

$$L(I) = \sum_{i=0}^{n} a_i \cdot I^i$$

mit n>0 dargestellt werden, wobei die Koeffizienten $a_i$ durch die Regressionsanalyse ermittelt werden.

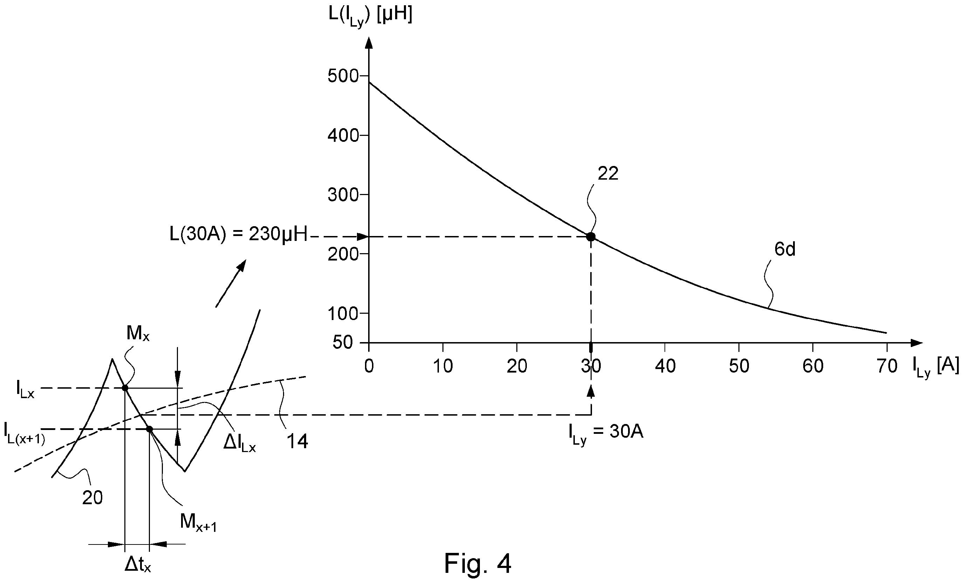

Wenn der qualitative Verlauf des Induktivitätsprofils 6 bekannt ist (bzw. als bekannt angenommen wird), kann das Induktivitätsprofil 6 gegebenenfalls anhand einer einzigen Ermittlung einer Induktivität bei einem bestimmten Spulenstrom ermittelt werden. In Fig. 2 zeigen die Linien 6a, 6b, und 6c mögliche qualitative Verläufe eines Induktivitätsprofils einer Spule, die mit einem ermittelten Induktivitätswert bei einem bestimmten Spulenstrom quantitativ in ihrer Lage angepasst werden können. Fig. 4 zeigt dies anhand eines Induktivitätsprofils 6d, das von 6a aus Fig. 2 mittels zuvor für einen Strom ($I_{Ly}$ = 30A) ermittelten Wert der Induktivität ($L(I_{Ly})$ = $230\mu H$) quantitativ in der Lage angepasst ist. Das Induktivitätsprofil 6d ist mit dem Wertepaar 22 aus $I_{Ly}$ und $L(I_{Ly})$ in seiner Lage bestimmt. Damit lässt sich in Fig. 4 in der Folge von einer Regeleinheit für einen beliebigen Strom $I_{Ly}$ ein Wert der Induktivität ermitteln. Im Beispiel in Fig. 4 wurde für $I_{Ly}$ ein Stromwert zwischen $I_x$ und $I_{x+1}$ definiert und mit 30A angenommen. Dies entspricht im dargestellten Fall in etwa dem Stromwert der Grundwelle 14 während der Messung. Wie bereits zuvor erwähnt, könnte $I_{Ly}$ auch mit $I_{Ly} = I_{Lx}$ oder in sinnvoller Weise beliebig anders definiert werden.

Üblicherweise stehen jedoch ausreichend viele Messungen zur Verfügung, um eine genauere Anpassung auf Basis mehrerer ermittelter Induktivitäten bei unterschiedlichem Spulenstrom durchzuführen.

Für ein bereits ermitteltes Induktivitätsprofil 6 kann in weiterer Folge die Steigung und Krümmung des Induktivitätsprofils 6 ermittelt werden. Wenn das Induktivitätsprofil 6 beispielsweise in Form eines Polynoms vorliegt ist dies mittels erster und zweiter Ableitung nach dem Strom besonders einfach möglich.

Mithilfe des Induktivitätsprofils 6 kann ein Parameter der Regelung laufend an den aktuellen Spulenstrom angepasst werden. Beispielsweise kann ein Proportionalregler mit variablem Verstärkungsfaktor $K_p(L(I))$ definiert werden. Der Wert des Verstärkungsfaktors $K_p$ passt sich dabei ständig an den aktuellen Wert des Stroms an, sodass über den gesamten (sinusförmigen) Stromverlauf immer der gerade passende Wert der Induktivität verwendet wird. Dadurch ist das dynamische Verhalten des Reglers unabhängig von der Stromamplitude des aktuellen Wechselstroms.

In einer erweiterten Ausführung kann mithilfe der Steigung des Induktivitätsprofils 6 ein Parameter der Regelung laufend an den aktuellen Spulenstrom angepasst werden, um die zu erwartende Änderung des Spulenstroms besser abschätzen zu können.

In einer erweiterten Ausführung für Arbeitsbereiche in denen die Induktivitätsprofile besonders ausgeprägt nicht-linear sind, kann zusätzlich mithilfe der Krümmung des Induktivitätsprofils 6 ein Parameter der Regelung laufend an den aktuellen Spulenstrom angepasst werden, um die zu erwartende Änderung des Spulenstroms noch besser abschätzen zu können.

Das obige Verfahren zur Ermittlung des Induktivitätsprofils 6 kann beispielsweise vor der ersten Inbetriebnahme des Wechselrichters 1 durchgeführt werden. Dies kann für

Filterspulen 2 ausreichend sein, deren Induktivitätsprofil über ihre Einsatzdauer nur sehr geringfügigen Änderungen unterworfen sind. Gegebenenfalls kann das Verfahren auch in planmäßigen Intervallen gemäß einem beliebigen Schema vor einer oder vor jeder Inbetriebnahme des Wechselrichters 1 durchgeführt werden. Das Schema kann beispielsweise an Bedingungen geknüpft sein. Beispielsweise kann die Ermittlung immer dann vor einer Inbetriebnahme durchgeführt werden, wenn bei einem letzten Betrieb ein für die Regelqualität charakteristischen Parameterbereich unter- bzw. überschritten wurde. Gegebenenfalls kann die Ermittlung des Induktivitätsprofils 6 auch regelmäßig, unregelmäßig oder ständig während des Betriebs des Wechselrichters 1 durchgeführt werden. Dies ist problemlos möglich, da die Ermittlung des Induktivitätsprofils 6 problemlos während des Echtbetriebs des Wechselrichters 1 durchgeführt werden kann. Beispielsweise kann die Regeleinheit 5 stichprobenartig die Übereinstimmung eines über eine Messung ermittelten Werts der Induktivität mit einem anhand des Induktivitätsprofils 6 ermittelten Wert prüfen. Sollte sich dabei eine zu große Abweichung ergeben, kann die Ermittlung und Aktualisierung des Induktivitätsprofils 6 während des Betriebs durchgeführt oder vor der nächsten Inbetriebnahme eingeplant werden.

Bezugszeichen:

Wechselrichter 1
Filterspule 2
Phasenleitung 3
Schaltungseinheit 4
Regeleinheit 5
Induktivitätsprofil 6
Gleichstromquelle 7
Filtereinheit 8
Netzrelais 9
Stromnetze 10
Filterkondensator 11
Strommesser 13
Grundwelle 14
Messpunkte 15, 16, 17
Geraden 18, 19
Spulenstrom iL 20
Spulenspannung $u_L$ 21
Wertepaar 22
Spulenstrom $i_L$
Phasenstrom $i_{ac}$
Spulenspannung $u_L$
rechteckige Wechselspannung $u_R$
Filterkondensatorspannung $u_{ac}$
Rechteck-Wechselspannung $u_R$
Flankensteigung m
Induktivität L

**Patentansprüche**

1. Verfahren zum Betreiben eines Wechselrichters (1), wobei das Verfahren die folgenden Schritte aufweist:

- mittels einer Schaltungseinheit (4) des Wechselrichters (1) Anlegen einer Wechselspannung an eine Phasenleitung (3), in der eine Filterinduktivität (2) angeordnet ist,
- Ermitteln von für einen Spulenstrom ($i_L$) und eine Spulenspannung ($u_L$) der Filterinduktivität (2) charakteristischen Werten im Bereich einer Mehrzahl von Messpunkten, wobei zumindest jeweils zwei Messpunkte an zumindest einer Flanke eines Stromrippels liegen,
- Ermitteln, aus den charakteristischen Werten, eines ersten Werts der Induktivität ($L(I_{L_y})$) der Filterinduktivität (2) für einen ersten Wert des Spulenstroms ($I_{L_y}$),
- Gegebenenfalls ermitteln zumindest eines weiteren Wertes der Induktivität der Filterinduktivität (2) für zumindest einen weiteren Wert des Spulenstroms,
- Ermitteln zumindest eines auf den Spulenstrom bezogenen Induktivitätsprofils (6) der Filterinduktivität (2) unter Verwendung des ermittelten ersten Wertes der Induktivität ($L(I_{L_y})$) der Filterinduktivität und gegebenenfalls unter Verwendung des zumindest einen weiteren ermittelten Wertes der Induktivität der Filterinduktivität,
- Regeln der Schaltungseinheit (4) des Wechselrichters (1) mittels einer Regeleinheit (5) zur Erzeugung eines Wechselstroms in der Phasenleitung (3), wobei zumindest ein Parameter der Regelung gemäß einem ermittelten stromabhängigen Induktivitätsprofil (6) laufend an den aktuellen Wert der Induktivität angepasst wird.

2. Verfahren nach Anspruch 1, **dadurch gekennzeichnet, dass** das Ermitteln des ersten Werts der Filterinduktivität die folgenden Schritte umfasst:

- Ermitteln einer ersten Flankensteigung ($m_x$) eines Stromrippels für den ersten Wert des Spulenstroms $I_{L_y}$,
- Ermitteln eines ersten Werts ($U_x$) der Spulenspannung bei der ersten Flankensteigung,
- Ermitteln des ersten Werts ($L(I_{L_y})$) der Filterinduktivität (2) aus der ersten Flankensteigung ($m_x$) und dem ersten Wert der Spulenspannung ($U_x$) gemäß der Formel

$$L(I_{L_y}) = \frac{U_x}{m_x} \ .$$

3. Verfahren nach Anspruch 1 oder 2, **dadurch gekennzeichnet, dass** die Ermittlung des Spulenstroms durch eine Messung mit einer Abtastfrequenz erfolgt, die zumindest dem zweifachen und vorzugsweise einem Vielfachen einer Taktfrequenz einer über die Schaltungseinheit (4) umgesetzten Pulsweitenmodulation entspricht.

4. Verfahren nach Anspruch 3, **dadurch gekennzeichnet, dass** die Flankensteigung durch Bilden der Stromdifferenz zwischen zumindest zwei Abtastschritten und unter Berücksichtigung der Abtastfrequenz ermittelt wird.

5. Verfahren nach Anspruch 1 bis 4, **dadurch gekennzeichnet, dass** nach der Ermittlung des Induktivitätsprofils (6) dessen Steigung und/oder Krümmung ermittelt wird.

6. Verfahren nach Anspruch 5, **dadurch gekennzeichnet, dass** bei der Regelung der Schaltungseinheit (4) des Wechselrichters (1) mittels einer Regeleinheit (5) zur Erzeugung eines Wechselstroms in einer Phasenleitung (3) zumindest ein Parameter der Regelung laufend an den aktuellen Wert der Steigung und/oder Krümmung des Induktivitätsprofils (6) angepasst wird.

7. Verfahren nach einem der Ansprüche 1 bis 6, **dadurch gekennzeichnet, dass** zumindest ein weiters Induktivitätsprofil einer weiteren Filterinduktivität in einer weiteren Phasenleitung ermittelt und bei der Regelung berücksichtigt wird.

8. Verfahren nach einem der Ansprüche 1 bis 7 **dadurch gekennzeichnet, dass** das Verfahren vor der ersten Inbetriebnahme des Wechselrichters (1) und/oder in planmäßigen Intervallen vor einer oder vor jeder Inbetriebnahme des Wechselrichters (1) und/oder regelmäßig oder ständig während des Betriebs des Wechselrichters (1) durchgeführt wird.

9. Verfahren nach einem der Ansprüche 1 bis 8, **dadurch gekennzeichnet, dass** in einem Stromrippel eine Mehrzahl an Werten der Filterinduktivität ermittelt und daraus ein Mittelwert gebildet wird, wobei das Induktivitätsprofil (6) der Filterinduktivität (2) unter Verwendung des Mittelwertes ermittelt wird.

10. Verfahren nach einem der Ansprüche 1 bis 9, **dadurch gekennzeichnet, dass** ein erstes Induktivitätsprofil aus Flanken mit positiver Steigung und ein zweites Induktivitätsprofil aus Flanken mit negativer Steigung ermittelt wird.

11. Verfahren nach einem der Ansprüche 1 bis 10, **dadurch gekennzeichnet, dass** für eine Mehrzahl von Stromamplituden eines Wechselstroms jeweils zumindest ein Induktivitätsprofil ermittelt wird.

12. Wechselrichter (1) mit einer Schaltungseinheit (4), mit der eine Wechselspannung an zumindest eine Phasenleitung (3) anlegbar ist, wobei in der Phasenleitung (3) eine Filterinduktivität (2) angeordnet ist und wobei die Schaltungseinheit (4) mittels einer Regeleinheit (5) geregelt wird, wobei ein Spulenstrom ($i_L$) der Filterinduktivität (2) und eine Spulenspannung ($u_L$) der Filterinduktivität (2) von der Regeleinheit (5) ermittelbar ist, und wobei die Regeleinheit (5) oder eine andere Recheneinheit des Wechselrichters ausgebildet ist, die folgenden Schritte auszuführen:

- Ansteuern der Schaltungseinheit (4) zum Anlegen einer Wechselspannung an eine Phasenleitung (3) des Wechselrichters (1),
- Ermitteln eines ersten Werts ($L(I_y)$) der Filterinduktivität (2) für einem ersten Wert des Spulenstroms ($I_y$),
- Gegebenenfalls ermitteln zumindest eines weiteren Wertes der Filterinduktivität für einem weiteren Wert des Spulenstroms,
- Ermitteln eines auf den Spulenstrom bezogenen Induktivitätsprofils (6) der Filterinduktivität (2) unter Verwendung des ermittelten ersten Wertes der Filterinduktivität und gegebenenfalls unter Verwendung des zumindest einen ermittelten weiteren Wertes der Filterinduktivität,
- Regeln der Schaltungseinheit (4) des Wechselrichters (1) zur Erzeugung eines Wechselstroms in der Phasenleitung (3), wobei zumindest ein Parameter der Regelung gemäß dem ermittelten stromabhängigen Induktivitätsprofil laufend an den aktuellen Spulenstrom angepasst wird.

13. Wechselrichter (1) nach Anspruch 12, **dadurch gekennzeichnet, dass** die Regeleinheit (5) oder eine andere Recheneinheit des Wechselrichters ausgebildet ist, das Induktivitätsprofil der Filterinduktivität (2) vor der ersten Inbetriebnahme des Wechselrichters (1) und/oder in planmäßigen Intervallen vor einer oder vor jeder Inbetriebnahme des Wechselrichters (1) und/oder regelmäßig oder ständig während des Betriebs des Wechselrichters (1) durchzuführen.

14. Wechselrichter (1) nach Anspruch 12 oder 13, **dadurch gekennzeichnet, dass** der Wechselrichter (1) mehrere Phasen (3) mit jeweils einer Filterinduktivität aufweist, wobei für jede Filterinduktivität ein Induktivitätsprofil ermittelbar ist.

15. Wechselrichter nach einem der Ansprüche 12 bis 14, **dadurch gekennzeichnet, dass** die Ermittlung des Induktionsprofils außerhalb der Regeleinheit durch einen dezidierten Mikrokontroller, eine Steuerung, oder einer anderen Recheneinheit durchgeführt wird.

Fig. 1

Fig. 2

Fig. 3a

Fig. 3b

Fig. 3c

Fig. 4

EP 3 836 383 A1

Europäisches Patentamt
European Patent Office
Office européen des brevets

**EUROPÄISCHER RECHERCHENBERICHT**

Nummer der Anmeldung

EP 19 21 4654

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WU FENGJIANG ET AL: "Improved Elimination Scheme of Current Zero-Crossing Distortion in Unipolar Hysteresis Current Controlled Grid-Connected Inverter", IEEE TRANSACTIONS ON INDUSTRIAL INFORMATICS, IEEE SERVICE CENTER, NEW YORK, NY, US, Bd. 11, Nr. 5, 1. Oktober 2015 (2015-10-01), Seiten 1111-1118, XP011670969, ISSN: 1551-3203, DOI: 10.1109/TII.2015.2470540 [gefunden am 2015-10-02] * Zusammenfassung; Abbildungen 1,2,8,9 * * Seite 1115 - Seite 1116 * ----- | 1-15 | INV. H02M7/5387 G01R27/26 ADD. H02M1/00 |
| A | EP 3 236 568 A1 (SIEMENS AG [DE]) 25. Oktober 2017 (2017-10-25) * Abbildung 1 * * Absätze [0051], [0052], [0057] * ----- | 1-15 | |
| | | | RECHERCHIERTE SACHGEBIETE (IPC) H02M G01R |

Der vorliegende Recherchenbericht wurde für alle Patentansprüche erstellt

| Recherchenort | Abschlußdatum der Recherche | Prüfer |
|---|---|---|
| Den Haag | 16. Juni 2020 | Kail, Maximilian |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 19 21 4654

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

16-06-2020

| Im Recherchenbericht angeführtes Patentdokument | Datum der Veröffentlichung | Mitglied(er) der Patentfamilie | Datum der Veröffentlichung |
|---|---|---|---|
| EP 3236568 A1 | 25-10-2017 | CN 109075696 A | 21-12-2018 |
| | | EP 3236568 A1 | 25-10-2017 |
| | | EP 3433922 A1 | 30-01-2019 |
| | | US 2019149034 A1 | 16-05-2019 |
| | | WO 2017182152 A1 | 26-10-2017 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20150016162 A1